# EUROPEAN PATENT SPECIFICATION

(11) **EP 1 924 666 B1**
(45) Date of publication and mention of the grant of the patent: **12.10.2011**
(21) Application number: 06813337.0
(22) Date of filing: 09.08.2006
(51) Int. Cl.: C09G 1/04, H01L 21/321

(54) **ABRASIVE-FREE POLISHING SYSTEM**
SCHLEIFFREIES POLIERSYSTEM
SYSTEME DE POLISSAGE EXEMPT D'ABRASIF

(30) Priority: 17.08.2005 US 205428
(43) Date of publication of application: 28.05.2008
(73) Proprietor: CABOT MICROELECTRONICS CORPORATION, Aurora, IL 60504 (US)
(72) Inventor: CHERIAN, Isaac, Aurora, Illinois 60504 (US); MOEGGENBORG, Kevin, Aurora, Illinois 60504 (US)
(74) Representative: Liesegang, Eva
(86) International application number: PCT/US2006/030982
(87) International publication number: WO 2007/021716

(56) References cited:
- WO-A-01/19935
- WO-A-02/063669
- US-A- 5 885 334

## Description

### FIELD OF THE INVENTION

This invention pertains to a polishing system and a method for polishing a substrate using the same.

### BACKGROUND OF THE INVENTION

Compositions and methods for planarizing or polishing the surface of a substrate, especially for chemical-mechanical polishing (CMP), are well known in the art. Polishing compositions (also known as polishing slurries) typically contain an abrasive material in an aqueous solution and are applied to a surface by contacting the surface with a polishing pad saturated with the polishing composition. Typical abrasive materials include silicon dioxide, cerium oxide, aluminum oxide, zirconium oxide, and tin oxide. The polishing composition is typically used in conjunction with a polishing pad (e.g., polishing cloth or disk). Alternatively, the abrasive material may be incorporated into the polishing pad. US-A-5,885,334 describes a polishing composition comprising an alkaline solution which contains a water-soluble silicide acid component and an alkaline component, and which has a pH value of 8.5 to 13 and is substantially free of abrasive particles. The polishing composition does not use an oxidizer. It is used for polishing silicon films.
WO 01/19935 A1 describes a polishing composition for copper polishing, the composition including abrasive particles and oxidizing agents.
WO 02/063669 A2 describes a polishing composition for polishing a substrate of copper/barrier/dielectric layers using three different polishing compositions. For the bulk copper removal, oxidizers are used.

Polishing compositions for silicon-based inter-metal dielectric layers have been particularly well developed in the semiconductor industry, and the chemical and mechanical nature of polishing and wearing of the silicon-based dielectrics is reasonably well understood. One problem with the silicon-based dielectric materials, however, is that their dielectric constant is relatively high, being approximately 3.9 or higher, depending on factors such as residual moisture content. As a result, the capacitance between the conductive layers is also relatively high, which in turn limits the speed (frequency) at which a circuit can operate. Strategies being developed to reduce the capacitance include (1) incorporating metals with lower resistivity values (e.g., copper), and (2) providing electrical isolation with insulating materials having lower dielectric constants relative to silicon dioxide.

One way to fabricate planar copper circuit traces on a silicon dioxide substrate is referred to as the damascene process. In accordance with this process, the silicon dioxide dielectric surface is patterned by a conventional dry etch process to form holes and trenches for vertical and horizontal interconnects. The patterned surface is coated with an adhesion-promoting layer such as titanium or tantalum and/or a diffusion barrier layer such as titanium nitride or tantalum nitride. The adhesion-promoting layer and/or the diffusion barrier layer are then over-coated with a copper layer. Chemical-mechanical polishing is employed to reduce the thickness of the copper over-layer, as well as the thickness of any adhesion-promoting layer and/or diffusion barrier layer, until a planar surface that exposes elevated portions of the silicon dioxide surface is obtained. The vias and trenches remain filled with electrically conductive copper forming the circuit interconnects.

Tantalum and tantalum nitride are particularly suitable materials for use in the damascene process as adhesion-promoting and/or diffusion barrier layers for copper-based devices. The properties of tantalum and of tantalum nitride differ from that of copper, being considerably more chemically inert, such that polishing compositions useful for the polishing of copper are often unsuitable for the removal of underlying tantalum and tantalum nitride. Thus, a two-step approach is generally used for the polishing of copper-tantalum dielectrics, with the first step comprising removal of most of the copper, and the second step comprising removal of the remaining copper and the barrier film (e.g., tantalum). The polishing of tantalum and tantalum nitride typically requires use of an abrasive. The abrasive often leads to scratching of copper remaining in the vias and trenches, and residual abrasive remaining on the surface often requires a subsequent post-polishing cleaning step, which leads to reduced device yield and increased manufacturing costs.

Thus, there remains a need in the art for improved polishing compositions and methods for chemical-mechanical polishing of substrates comprising tantalum.

### BRIEF SUMMARY OF THE INVENTION

The invention provides a chemical-mechanical polishing system for polishing a substrate comprising (a) a water-soluble silicate compound, (b) an oxidizing agent that oxidizes at least a part of a substrate, (c) water, and (d) a polishing pad, wherein the polishing system is substantially free of abrasive particles. The invention further provides a method of polishing a substrate, which method comprises (i) contacting a substrate with a polishing system comprising (a) a water-soluble silicate compound, (b) an oxidizing agent that oxidizes at least a part of the substrate, (c) water, and (d) a polishing pad, wherein the polishing system is substantially free of abrasive particles, (ii) moving the polishing pad relative to the substrate, and (iii) abrading at least a portion of the substrate to polish the substrate.

### DETAILED DESCRIPTION OF THE INVENTION

The invention provides a chemical-mechanical polishing system comprising (a) a water-soluble silicate compound, (b) an oxidizing agent that oxidizes at least a part of a substrate, (c) water, and (d) a polishing pad. The polishing system is substantially free of abrasive particles.

The polishing system comprises a water-soluble silicate compound. The water-soluble silicate compound can be any suitable water-soluble silicate compound. Desirably, the water-soluble silicate compound is an alkali metal silicate. Preferably, the water-soluble silicate compound is selected from the group consisting of potassium silicate, sodium silicate, potassium metasilicate, and sodium metasilicate. More preferably, the water-soluble silicate compound is potassium silicate.

Water-soluble silicate compounds suitable for use in the invention can be silicate glasses. Silicate glasses are typically prepared by high-temperature fusion of silica sand with a suitable alkali metal compound (e.g., sodium carbonate or potassium carbonate).

Water-soluble silicates have the general formula _{M2}O·mSiO₂·nH₂O, where M is an alkali metal selected from the group consisting of sodium, potassium and lithium, and m, referred to as the modulus, and n are the number of moles of SiO₂ and H₂O, respectively, per mole of M₂O. The modulus m is the molar ratio of SiO₂ to M₂O. The weight ratio of SiO₂ to M₂O is also commonly used to describe the composition of water-soluble alkali metal silicates. The modulus m can be any suitable positive nonzero number, typically 1 to 4, and more typically 2 to 4 (e.g., 2.8 to 3.9, or 3 to 3.6).

In a preferred embodiment, the water-soluble silicate compound is potassium silicate having a general formula M₂O·mSiO₂ wherein the modulus m (e.g., the molar ratio of SiO₂ to M₂O) is a positive nonzero number. The water-soluble potassium silicate can have any suitable modulus. Preferably, the modulus is 2.8 to 3.9. More preferably, the modulus is 3 to 3.6.

The water-soluble silicate compound is present in aqueous solution in the inventive polishing composition. A method of providing the water-soluble silicate compound is to dissolve a solid form of the water-soluble silicate compound in water to provide a solution. Alternatively, a concentrated solution of the water-soluble silicate compound can be diluted to obtain the desired concentration of SiO₂ in solution. Various grades of potassium silicate and sodium silicate solutions in water are available commercially, wherein the solutions are characterized by the particular modulus of the silicates used in their preparation, as well as wt.% SiO₂ and wt.% K₂O or Na₂O of the solutions. Zaclon, Inc. (Cleveland, OH) and PQ Corporation (Valley Forge, PA) are two major suppliers of both solid forms and solutions of potassium silicate and sodium silicate.

Aqueous solutions of potassium silicate also can be obtained by hydrothermal processes, wherein a silicon dioxide (e.g., SiO₂) source is reacted with aqueous solutions of potassium hydroxide under conditions of elevated temperature and/or pressure. Examples of suitable hydrothermal processes for production of aqueous solutions of potassium silicate are disclosed in U.S. Patents 5,084,262 and 5,238,668.

The polishing system can comprise any suitable amount of the water-soluble silicate compound. Generally, the content of water-soluble silicate compound present in the polishing system is expressed as the weight percent of SiO₂ provided by the water-soluble silicate compound, based on the total weight of water and any components dissolved therein. Typically, the polishing system comprises sufficient water-soluble silicate compound to provide 0.1 wt.% or more (e.g., 0.2 wt.% or more, 0.5 wt.% or more, or 1 wt.% or more) of SiO₂, based on the total weight of the water and any components dissolved therein. The polishing system preferably comprises sufficient water-soluble silicate compound to provide 8 wt.% or less (e.g., 6 wt.% or less, or 4 wt.% or less, or even 2 wt.% or less) of SiO₂, based on the total weight of water and any components dissolved therein. The polishing system most preferably comprises 0.5 wt.% to 2 wt.% SiO₂ based on the total weight of the water and any components dissolved therein.

The polishing system can have any suitable pH. In a first embodiment, the polishing system desirably has a pH of 9 or more (e.g., 10 or more, or 11 or more). Preferably, the polishing system has a pH of 9 to 12, more preferably 10 to 12, and even more preferably 11 to 12.

In a second embodiment, the polishing system desirably has a pH of 4 or less (e.g., 3 or less). Preferably, the polishing system has a pH of 2 to 3.

Aqueous solutions of water-soluble silicate compounds obtained by dissolution of silicate glasses (e.g., alkali metal silicates) or prepared by hydrothermal processes have a strongly basic pH of 11 or more, being composed of a salt of a strong base and a weak acid, and are stable to precipitation of solid material or formation of gels. When the pH is lowered to values below pH 11, the solutions will form high molecular weight silicic acid polymers that form silica hydrogels over time. The kinetics of silica hydrogel formation (e.g., the rate at which the silica hydrogels form) will depend on several factors, of which the pH, ionic strength of the solution, concentration, and temperature are considered important. Stability of the aqueous solutions of water-soluble silicate compounds to precipitation or gel formation is generally highest at a pH greater than 9 and a pH lower than 4.

Desirably, the polishing system is used before any gel or precipitate is visually observable. The time between preparation and use of the polishing composition will vary based on the pH, concentration of SiO₂, the oxidizing agent, and any optional components present in the polishing system, as well as the temperature to which the polishing system is subjected. The inventive method disclosed herein provides for use of the polishing system while the polishing system remains substantially free of particulate matter or of a gel during its use in the polishing of a substrate.

The polishing system comprises an oxidizing agent that oxidizes at least a part of a substrate. Any suitable oxidizing agent can be used in conjunction with the invention. Preferably, the oxidizing agent is selected from the group consisting of hydrogen peroxide, potassium iodate, potassium permanganate, ammonium persulfate, potassium hydrogen peroxymonosulfate sulfate, ammonium molybdate, ferric nitrate, potassium nitrate, and combinations thereof. More preferably, the oxidizing agent is hydrogen peroxide. The polishing system typically comprises 0.1 wt.% or more (e.g., 0.2 wt.% or more, or 0.5 wt.% or more, or 1 wt.% or more) of an oxidizing agent, based on the total weight of water and any components dissolved therein. The polishing system generally comprises 10 wt.% or less (e.g., 8 wt.% or less, or 5 wt.% or less, or 3 wt.% or less) of an oxidizing agent, based on the total weight of water and any components dissolved therein.

The polishing system optionally further comprises calcium ion. The calcium ion can be provided by any suitable water-soluble calcium compound. A preferred source of calcium ion is calcium chloride. When present, typically the polishing composition comprises 0.1 ppm or more (e.g., 1 ppm or more, or 5 ppm or more) of calcium ion, based on the total weight of water and any components dissolved therein. Generally, the polishing composition comprises 50 ppm or less (e.g., 40 ppm or less, or 30 ppm or less) of calcium ion, based on the total weight of water and any components dissolved therein.

If desired, the pH of the polishing system can be adjusted by acidifying a strongly basic solution of a water-soluble silicate compound by the addition of a sufficient amount of an acid to neutralize sufficient M₂O that is present to obtain the desired pH. The acid can be any suitable acid strong enough to produce the desired final pH. Non-limiting examples of suitable acids include hydrochloric acid, nitric acid, sulfuric acid, phosphoric acid, formic acid, acetic acid, and mixtures thereof. The pH of the polishing composition can be adjusted at any suitable time. For example, the pH of the polishing system can be adjusted before adding the oxidizing agent and any optional components. In other embodiments, the solution of a water-soluble silicate compound is combined with the oxidizing agent and any optional components prior to adjustment of the pH of the system. In still other embodiments, the pH of the system is adjusted at the point-of-use (e.g., at the surface of the substrate).

The pH can also be adjusted by the use of a buffering agent. Typically, a buffering agent comprises an acid and its conjugate base. When a buffering agent is used to adjust the pH of the polishing system, it will be understood that sufficient buffering agent will be added to the polishing system to neutralize sufficient M₂O to provide the desired pH. The pH buffering agent can be any suitable buffering agent, for example, phosphates, sulfates, acetates, borates, ammonium salts, and the like. The polishing system can comprise any suitable amount of a pH adjustor (e.g., an acid or a base) and/or a pH buffering agent, provided that a suitable amount is used to achieve and/or maintain the pH. of the polishing system within the desired pH ranges.

The polishing system optionally further comprises one or more other additives. Such additives include any suitable surfactant and/or rheological control agent. Suitable surfactants include, for example, cationic surfactants, anionic surfactants, anionic polyelectrolytes, nonionic surfactants, amphoteric surfactants, fluorinated surfactants, mixtures thereof, and the like.

The polishing system optionally further comprises an antifoaming agent. The anti-foaming agent can be any suitable anti-foaming agent. Suitable antifoaming agents include, but are not limited to, silicon-based and acetylenic diol-based antifoaming agents. The amount of anti-foaming agent present in the polishing system typically is 40 ppm to 140 ppm, based on the total weight of water and any components dissolved therein.

The polishing system optionally further comprises a biocide. The biocide can be any suitable biocide, for example an isotliazolinone biocide. The amount of biocide used in the polishing system typically is 1 ppm to 500 ppm, and preferably is 10 ppm to 200 ppm.

Any of the components used in conjunction with the invention can be provided in the form of a mixture or solution in water. Two or more components then desirably are individually stored and subsequently mixed to form the polishing system. In this regard, it is suitable for the polishing system to be prepared (e.g., for all the components to be mixed together) and then delivered to the surface of the substrate prior to the appearance of any gel or particulate matter. It is also suitable for the polishing system to be prepared on the surface of the substrate, through delivery of the components of the polishing system from two or more distinct sources, whereby the components of the polishing system meet at the surface of the substrate (e.g., at the point-of-use). In either case, the flow rate at which the components of the polishing system are delivered to the surface of the substrate (i.e., the delivered amount of the particular components of the polishing system) can be altered prior to the polishing process and/or during the polishing process, such that the polishing characteristics, such as the polishing rate, of the polishing system is altered.

While the components of the polishing system can be combined well before or even shortly before use, the components of the polishing composition can be combined at or near the point-of use. As utilized herein, the term "point-of-use" refers to the point at which the polishing system is contacted with the substrate surface). When the components of the polishing system are to be combined using point-of-use mixing, the components of the polishing system are separately stored in two or more storage devices.

In order to mix components of the polishing system contained in storage devices at or near the point-of-use, the storage devices typically are provided with one or more flow lines leading from each storage device to the point-of-use of the polishing system (e.g., the platen or the substrate surface). By the term "flow line" is meant a path of flow from an individual storage container to the point-of-use of the component stored therein. The one or more flow lines can each lead directly to the point-of-use, or, in the case that more than one flow line is used, two or more of the flow lines can be combined at any point into a single flow line that leads to the point-of-use. Furthermore, any of the one or more flow lines (e.g., the individual flow lines or a combined flow line) can first lead to one or more of the other devices (e.g., pumping device, measuring device, mixing device, etc.) prior to reaching the point-of-use of the component(s).

The components of the polishing system can be delivered to the point-of-use independently (e.g., the components are delivered to the substrate surface whereupon the components are mixed during the polishing process), or the components can be combined immediately before delivery to the point-of-use. Components are combined "immediately before delivery to the point-of-use" if they are combined less than 10 seconds prior to reaching the point-of-use, preferably less than 5 seconds prior to reaching the point-of-use, more preferably less than 1 second prior to reaching the point of use, or even simultaneous to the delivery of the components at the point-of-use (e.g., the components are combined at a dispenser). Components also are combined "immediately before delivery to the point-of-use" if they are combined within 5 m of the point-of-use, such as within 1 m of the point-of-use or even within 10 cm of the point-of-use (e.g., within 1 cm of the point of use).

When two or more of the components of the polishing system are combined prior to reaching the point-of-use, the components can be combined in the flow line and delivered to the point-of-use without the use of a mixing device. Alternatively, one or more of the flow lines can lead into a mixing device to facilitate the combination of two or more of the components. Any suitable mixing device can be used. For example, the mixing device can be a nozzle or jet (e.g., a high pressure nozzle or jet) through which two or more of the components flow. Alternatively, the mixing device can be a container-type mixing device comprising one or more inlets by which two or more components of the polishing system are introduced to the mixer, and at least one outlet through which the mixed components exit the mixer to be delivered to the point-of-use, either directly or via other elements of the apparatus (e.g., via one or more flow lines). Furthermore, the mixing device can comprise more than one chamber, each chamber having at least one inlet and at least one outlet, wherein two or more components are combined in each chamber. If a container-type mixing device is used, the mixing device preferably comprises a mixing mechanism to further facilitate the combination of the components. Mixing mechanisms are generally known in the art and include stirrers, blenders, agitators, paddled baffles, gas sparger systems, vibrators, etc.

The polishing system comprises any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof.

Although the polishing system of the invention is useful for polishing any substrate, the polishing system is particularly useful in the polishing of a substrate comprising at least one metal layer comprising tantalum. The substrate can be any suitable tantalum-containing substrate (e.g., an integrated circuit, metals, ILD layers, semiconductors, thin films, MEMS, magnetic heads) and can further comprise any suitable insulating, metal, or metal alloy layer (e.g., metal conductive layer). The insulating layer can be a metal oxide, porous metal oxide, glass, organic polymer, fluorinated organic polymer, or any other suitable high or low-κ insulating layer. The insulating layer preferably is a silicon-based metal oxide. The substrate preferably further comprises a metal layer comprising copper.

The invention further provides a method of polishing a substrate using the polishing composition of the invention. In particular, the method of the invention comprises (i) contacting a substrate with a polishing system comprising (a) a water-soluble silicate compound, (b) an oxidizing agent that oxidizes at least a part of the substrate, (c) water, and (d) a polishing pad, wherein the polishing system is substantially free of abrasive particles, (ii) moving the polishing pad relative to the substrate, and (iii) abrading at least a portion of the substrate to polish the substrate.

In accordance with the invention, the substrate can be polished with the polishing system described herein by any suitable technique. The method of the invention is particularly well-suited for use in conjunction with a chemical-mechanical polishing (CMP) apparatus. Typically, the apparatus comprises a platen, which, when in use, is in motion and has a velocity that results from orbital, linear, or circular motion, a polishing pad in contact with the platen and moving with the platen when in motion, and a carrier that holds a substrate to be polished by contacting and moving relative to the surface of the polishing pad. The polishing of the substrate takes place by the substrate being placed in contact with the polishing system of the invention, and by the polishing pad moving relative to the substrate, with the other components of the polishing system therebetween, so as to abrade and remove a portion of the substrate so as to polish at least a portion of the substrate.

When the method of the invention is practiced in conjunction with a CMP apparatus, the polishing pad of the polishing system comprises the polishing pad of the CMP apparatus. The polishing pad can be as previously recited.

Desirably, the CMP apparatus further comprises an *in situ* polishing endpoint detection system, many of which are known in the art. Techniques for inspecting and monitoring the polishing process by analyzing light or other radiation reflected from a surface of the substrate are known in the art. Desirably, the inspection or monitoring of the progress of the polishing process with respect to a substrate being polished enables the determination of the polishing end-point, i.e., the determination of when to terminate the polishing process with respect to a particular substrate.

The following examples further illustrate the invention but, of course, should not be construed as in any way limiting its scope.

In the examples below, similar substrates comprising a layer of tantalum on a substrate of silicon dioxide were polished using a Logitech CDP polishing apparatus. The polishing parameters were as follows: 9.3 kPa (1.35 psi) down force, 69 rpm platen speed, 65 rpm carrier speed, and 160 mL/min polishing composition flow rate, and use of an in-situ conditioned concentric groove CMP pad.

### EXAMPLE 1

This example shows the effect of increasing concentrations of potassium silicate on the removal rates for tantalum layers observed with the polishing system of the invention.

Similar substrates comprising a layer of tantalum over silicon dioxide were separately polished with four different polishing systems (Systems 1A-1D). Each of the systems consisted of 3 wt.% hydrogen peroxide in water at a pH of 11 and varying amounts of potassium silicate, expressed as the final concentration of SiO₂ provided by the potassium silicate, as set forth in Table 1. The potassium silicate was provided by dilution of a 30 wt.% solution of potassium silicate in water (Kasil 2130; PQ Corp., Valley Forge, PA) to provide the recited concentrations of SiO₂. All of the polishing systems were homogeneous by visual inspection before and after use. Following use of the polishing systems, the tantalum removal rates were determined. The results are set forth in Table 1.

**Table 1: Effect of concentration of potassium silicate on tantalum removal rate**

| System | Wt.% SiO₂ (as potassium silicate) | Tantalum Removal Rate (Å/min) |
|---|---|---|
| 1A (invention) | 0.25 | 14 |
| 1B (invention) | 0.75 | 70 |
| 1C (invention) | 2.0 | 236 |
| 1D (invention) | 6.0 | 318 |

These results demonstrate that the tantalum removal rate exhibited by the polishing system comprising soluble potassium silicate depends on the concentration of soluble potassium silicate present in the polishing system. Concentrations of soluble potassium silicate providing 2 wt.% or more, specifically 2.0 wt.% and 6.0 wt.%, of SiO₂ (Systems 1C and 1D) exhibit practical tantalum removal rates without use of an abrasive.

### EXAMPLE 2

This example shows the effect of increasing concentrations of potassium silicate in the presence of added calcium ion on the removal rates for tantalum layers observed with the polishing systems of the invention.

Similar substrates comprising a layer of tantalum over silicon dioxide were separately polished with five different polishing systems (Systems 2A-2E). Systems 2A-2D consisted of 3 wt.% hydrogen peroxide in water at a pH of 11, 20 ppm of calcium ion (as calcium chloride), and varying amounts of potassium silicate, expressed as the final concentration of SiO₂ provided by the potassium silicate, as set forth in Table 2. System 2E was a comparative polishing system comprising 6 wt.% fumed silica (abrasive particles), 0.5 wt.% potassium acetate, 0.05 wt.% benzotriazole, 3 wt.% hydrogen peroxide, and 20 ppm calcium ion (as calcium chloride) in water at a pH of 10. The potassium silicate was provided by dilution of a 30 wt.% solution of potassium silicate in water (Kasil 2130; PQ Corp., Valley Forge, PA) to provide the recited concentrations of SiO₂. All of the inventive polishing systems were homogeneous by visual inspection before and after use. Following use of the polishing systems, the tantalum removal rates were determined. The results are set forth in Table 2.

**Table 2: Effect of concentration of potassium silicate with added calcium ion on tantalum removal rate**

| System | Wt.% SiO₂ (as potassium silicate) | Tantalum Removal Rate (Å/min) |
|---|---|---|
| 2A (invention) | 0.25 | 232 |
| 2B (invention) | 0.75 | 324 |
| 2C (invention) | 2.0 | 482 |
| 2D (invention) | 6.0 | 289 |
| 2E (comparative) | 0 | 456^{*} |

| | | |
|---|---|---|
| ^{*} average of two experiments | | |

These results demonstrate that the tantalum removal rate exhibited by polishing systems comprising soluble potassium silicate and 20 ppm of calcium ion depends on the concentration of soluble potassium silicate present in the polishing system, with practical tantalum removal rates being achieved with 0.25 wt.% or more SiO₂ and a maximum tantalum removal rate observed with 2.0 wt.% SiO₂. The tantalum removal rate observed with 2.0 wt.% SiO₂ and 20 ppm calcium ion (System 2C) was essentially equal to the tantalum removal rate observed with a comparative system comprising fumed silica abrasive particles (System 2E).

## Claims

1. A chemical-mechanical polishing system for polishing a substrate comprising:
(a) a water-soluble silicate compound,
(b) an oxidizing agent that oxidizes at least a part of a substrate,
(c) water, and
(d) a polishing pad,
wherein the polishing system is substantially free of abrasive particles:

2. The polishing system of claim 1, wherein the water-soluble silicate compound is selected from the group consisting of potassium silicate, sodium silicate, potassium metasilicate, and sodium metasilicate.

3. The polishing system of claim 2, wherein the water-soluble silicate compound is potassium silicate and the potassium silicate has a SiO₂:K₂O molar ratio of 2.8 to 3.9, preferably of 3 to 3.6.

4. The polishing system of one of the preceding claims, wherein the oxidizing agent is selected from the group consisting of hydrogen peroxide, potassium iodate, potassium permanganate, ammonium persulfate, potassium hydrogen peroxymonosulfate sulfate, ammonium molybdate, ferric nitrate, potassium nitrate, and combinations thereof.

5. The polishing system of one of the preceding claims , wherein the polishing system has a pH of 9 or more, preferably a pH of 10 to 12.

6. The polishing system of one of claims 1 to 4, wherein the polishing system has a pH of 4 or less, preferably a pH of 2 to 3.

7. The polishing system of one of the preceding claims, wherein the polishing system further comprises 1 ppm to 50 ppm of calcium ion.

8. A method of polishing a substrate, which method comprises:
(i) contacting a substrate with a polishing system comprising:
(a) a water-soluble silicate compound,
(b) an oxidizing agent that oxidizes at least a part of the substrate,
(c) water, and
(d) a polishing pad,
wherein the polishing system is substantially free of abrasive particles,
(ii) moving the polishing pad relative to the substrate, and
(iii) abrading at least a portion of the substrate to polish the substrate.

9. The method of claim 8, wherein the water-soluble silicate compound is selected from the group consisting of potassium silicate, sodium silicate, potassium metasilicate, and sodium metasilicate.

10. The method of claim 9, wherein the water-soluble silicate compound is potassium silicate and the potassium silicate has a SiO₂:K₂O molar ratio of 2.8 to 3.9, preferably of 3 to 3.6.

11. The method of one of claims 8 to 10, wherein the oxidizing agent is selected from the group consisting of hydrogen peroxide, potassium iodate, potassium permanganate, ammonium persulfate, potassium hydrogen peroxymonosulfate sulfate, ammonium molybdate, ferric nitrate, potassium nitrate, and combinations thereof.

12. The method of one of claims 8 to 11, wherein the polishing system has a pH of 9 or more, preferably a pH of 10 to 12.

13. The method of one of claims 8 to 11, wherein the polishing system has a pH of 4 or less, preferably a pH of 2 to 3.

14. The method of one of claims 8 to 13, wherein the polishing system further comprises 1 ppm to 50 ppm of calcium ion.

15. The method of one of claims 8 to 14, wherein the substrate comprises tantalum and in particular, tantalum and copper.

## Patentansprüche

1. Chemisch-mechanisches Poliersystem zum Polieren eines Substrats, mit:
(a) einer wasserlöslichen Silikatverbindung,
(b) einem Oxidationsmittel, das wenigstens einen Teil eines Substrats oxidiert,
(c) Wasser, und
(d) einem Polierpolster,
wobei das Poliersystem weitgehend frei von Schleifpartikeln ist.

2. Poliersystem nach Anspruch 1, wobei die wasserlösliche Silikatverbindung ausgewählt ist aus der Gruppe, welche besteht aus: Kaliumsilikat, Natriumsilikat, Kaliummetasilikat und Natriummetasilikat.

3. Poliersystem nach Anspruch 2, wobei die wasserlösliche Silikatverbindung Kaliumsilikat ist und das Kaliumsilikat ein Molarverhältnis von SiO₂:K₂O von 2,8 bis 3,9, vorzugsweise von 3 bis 3,6 hat.

4. Poliersystem nach einem der vorangehenden Ansprüche, wobei das Oxidationsmittel ausgewählt ist aus der Gruppe, welche besteht aus: Wasserstoffperoxid, Kaliumiodat, Kaliumpermanganat, Ammoniumpersulfat, Kaliumwasserstoff Peroxymonosulfat-Sulfat, Ammoniummolybdat, Eisennitrat, Kaliumnitrat und Kombinationen hiervon.

5. Poliersystem nach einem der vorangehenden Ansprüche, wobei das Poliersystem einen pH-Wert von 9 oder mehr, vorzugsweise einen pH-Wert von 10 bis 12 hat.

6. Poliersystem nach einem der Ansprüche 1 bis 4, wobei das Poliersystem einen pH-Wert von 4 oder weniger, vorzugsweise einen pH-Wert von 2 bis 3 hat.

7. Poliersystem nach einem der vorangehenden Ansprüche, wobei das Poliersystem ferner 1 ppm bis 50 ppm Kalziumionen aufweist.

8. Verfahren zum Polieren eines Substrats mit den Verfahrensschritten:
(i) Kontaktieren eines Substrats mit einem Poliersystem, welches umfasst:
(a) eine wasserlösliche Silikatverbindung,
(b) ein Oxidationsmittel, das wenigstens einen Teil des Substrats oxidiert,
(c) Wasser und
(d) ein Polierpolster,
wobei das Poliersystem weitgehend frei von Schleifpartikeln ist,
(ii) Bewegen des Polierpolsters relativ zu dem Substrat und
(iii) Abtragen wenigstens eines Teils des Substrats, um das Substrat zu polieren.

9. Verfahren nach Anspruch 8, wobei die wasserlösliche Silikatverbindung ausgewählt wird aus der Gruppe, welche besteht aus: Kaliumsilikat, Natriumsilikat, Kaliummetasilikat und Natriummetasilikat.

10. Verfahren nach Anspruch 9, wobei die wasserlösliche Silikatverbindung Kaliumsilikat ist und das Kaliumsilikat ein Molarverhältnis von SiO₂:K₂O von 2,8 bis 3,9, vorzugsweise von 3 bis 3,6 hat.

11. Verfahren nach einem der Ansprüche 8 bis 10, wobei das Oxidationsmittel ausgewählt wird aus der Gruppe, welche besteht aus: Wasserstoffperoxid, Kaliumiodat, Kaliumpermanganat, Ammoniumpersulfat, Kaliumwasserstoff Peroxymonosulfat-Sulfat, Ammoniummolybdat, Eisennitrat, Kaliumnitrat und Kombinationen hiervon.

12. Verfahren nach einem der Ansprüche 8 bis 11, wobei das Poliersystem einen pH-Wert von 9 oder mehr, vorzugsweise einen pH-Wert von 10 bis 12 hat.

13. Verfahren nach einem der Ansprüche 8 bis 11, wobei das Poliersystem einen pH-Wert von 4 oder weniger, vorzugsweise einen pH-Wert von 2 bis 3 hat.

14. Verfahren nach einem der Ansprüche 8 bis 13, wobei das Poliersystem ferner 1 ppm bis 50 ppm Kalziumionen aufweist.

15. Verfahren nach einem der Ansprüche 8 bis 14, wobei das Substrat Tantal, insbesondere Tantal und Kupfer aufweist.

## Revendications

1. Système de polissage chimico-mécanique pour polir un substrat, comprenant :
(a) un composé de silicate soluble dans l'eau,
(b) un agent oxydant qui oxyde au moins une partie d'un substrat,
(c) de l'eau, et
(d) un tampon de polissage,
le système de polissage étant sensiblement exempt de particules abrasives.

2. Système de polissage selon la revendication 1, dans lequel le composé de silicate soluble dans l'eau est choisi dans le groupe comprenant le silicate de potassium, le silicate de sodium, le métasilicate de potassium et le métasilicate de sodium.

3. Système de polissage selon la revendication 2, dans lequel le composé de silicate soluble dans l'eau est du silicate de potassium et le silicate de potassium a un rapport molaire SiO₂:K₂O de 2,8 à 3,9, de préférence de 3 à 3,6.

4. Système de polissage selon l'une quelconque des revendications précédentes, dans lequel l'agent oxydant est choisi dans le groupe comprenant le peroxyde d'hydrogène, l'iodate de potassium, le permanganate de potassium, le persulfate d'ammonium, le sulfate de peroxymonosulfate d'hydrogène de potassium, le molybdate d'ammonium, le nitrate ferrique, le nitrate de potassium et leurs combinaisons.

5. Système de polissage selon l'une quelconque des revendications précédentes, le système de polissage ayant un pH de 9 ou plus, de préférence un pH de 10 à 12.

6. Système de polissage selon l'une quelconque des revendications 1 à 4, le système de polissage ayant un pH de 4 ou moins, de préférence un pH de 2 à 3.

7. Système de polissage selon l'une quelconque des revendications précédentes, le système de polissage comprenant en outre 1 ppm à 50 ppm d'ions calcium.

8. Procédé de polissage d'un substrat, le procédé comprenant les étapes suivantes :
(i) mettre en contact un substrat avec un système de polissage comprenant :
(a) un composé de silicate soluble dans l'eau,
(b) un agent oxydant qui oxyde au moins une partie du substrat,
(c) de l'eau, et
(d) un tampon de polissage,
le système de polissage étant sensiblement exempt de particules abrasives,
(ii) déplacer le tampon de polissage par rapport au substrat, et
(iii) abraser au moins une partie du substrat pour polir le substrat.

9. Procédé selon la revendication 8, dans lequel le composé de silicate soluble dans l'eau est choisi dans le groupe comprenant le silicate de potassium, le silicate de sodium, le métasilicate de potassium et le métasilicate de sodium.

10. Procédé selon la revendication 9, dans lequel le composé de silicate soluble dans l'eau est du silicate de potassium et le silicate de potassium a un rapport molaire SiO₂:K₂O de 2,8 à 3,9, de préférence de 3 à 3,6.

11. Procédé selon l'une quelconque des revendications 8 à 10, dans lequel l'agent oxydant est choisi dans le groupe comprenant le peroxyde d'hydrogène, l'iodate de potassium, le permanganate de potassium, le persulfate d'ammonium, le sulfate de peroxymonosulfate d'hydrogène de potassium, le molybdate d'ammonium, le nitrate ferrique, le nitrate de potassium et leurs combinaisons.

12. Procédé selon l'une quelconque des revendications 8 à 11, dans lequel le système de polissage a un pH de 9 ou plus, de préférence un pH de 10 à 12.

13. Procédé selon l'une quelconque des revendications 8 à 11, dans lequel le système de polissage a un pH de 4 ou moins, de préférence un pH de 2 à 3.

14. Procédé selon l'une quelconque des revendications 8 à 13, dans lequel le système de polissage comprend en outre 1 ppm à 50 ppm d'ions calcium.

15. Procédé selon l'une quelconque des revendications 8 à 14, dans lequel le substrat comprend du tantale et en particulier, du tantale et du cuivre.
